(19) Europäisches Patentamt
European Patent Office
Office européen des brevets

(11) **EP 1 744 351 A2**

(12) **EUROPEAN PATENT APPLICATION**

(43) Date of publication:
**17.01.2007 Bulletin 2007/03**

(51) Int Cl.:
*H01L 21/28* (2006.01)　　　*H01L 29/49* (2006.01)

(21) Application number: **05447277.4**

(22) Date of filing: **09.12.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **11.07.2005 US 698046 P**

(71) Applicants:
- **INTERUNIVERSITAIR MICROELEKTRONICA CENTRUM ( IMEC)**
  **3001 Leuven (BE)**
- **Koninklijke Philips Electronics N.V.**
  **5621 BA Eindhoven (NL)**
- **TEXAS INSTRUMENTS INCORPORATED**
  **Dallas, Texas 75265 (US)**

(72) Inventors:
- **Kittl, Jorge Adrian**
  **1410 Waterloo (BE)**
- **Lauwers, Anne**
  **2630 Aartselaar (BE)**
- **Veloso, Anabela**
  **3001 Leuven (BE)**
- **Kottantharayil, Anil**
  **3000 Leuven (BE)**
- **Van Dal, Marcus Johannes Henricus**
  **3000 Leuven (BE)**

(74) Representative: **Van Malderen, Joëlle et al**
  **pronovem - Office Van Malderen**
  **Avenue Josse Goffin 158**
  **1082 Bruxelles (BE)**

(54) **Method for forming a fully silicided gate MOSFET and devices obtained thereof**

(57)　　A method for manufacturing a MOSFET device with a fully silicided (FUSI) gate is described. This method may be used to prevent formation of shorts between the FUSI gate and a contact to a source and/or a drain region. In particular, the method discloses the formation of an expansion volume above a gate dielectric. The volume is designed to substantially contain the fully silicided gate.

Fig. 3c

**Description**

**Field of the Invention**

The present invention relates to semiconductor process technology and devices. In particular, the present invention relates to semiconductor devices with metallic gate electrodes formed by a reaction between a metal and a semiconductor material.

**Background of the Invention**

MOSFET (Metal-Oxide-Silicon Field Effect Transistors) devices comprise a gate electrode, a gate dielectric, and a channel formed in or on a substrate. The gate dielectric dielectrically couples the channel to the gate electrode so that the gate electrode potential can modulate the conductivity of the channel. There is a trend to replace semiconductor gate electrodes with metal gate electrodes. Metal gate electrodes offer the advantages of reducing the sheet resistance, eliminating the semiconductor gate depletion effect, and controlling the work function independently from the doping of the junction regions.

Metal gate electrodes can be formed by full silicidation (FUSI) of the semiconductor gate electrode with a metal. The semiconductor gate electrode may be a polysilicon gate electrode. The metal may be a refractory metal such as W, noble metals such as Pt, near noble metals such as Ni, transition metals such as Ti, or any combination thereof. During this silicidation process, the gate electrode is converted into a silicide.

Various manufacturing methods and materials exist to form FUSI gate MOSFET devices using full silicidation of the semiconductor gate electrode. W. Maszara et al. discloses in "Transistors with Dual Work Function Metal Gates by Single Full Silicidation (FUSI) of Polysilicon gates," IEDM proceedings 2002 p367-370, the use of nickel-silicides to form a FUSI gate. According to this approach, the FUSI gate of a MOSFET device is formed during a single silicidation step using nickel as silicidation metal. The work function of the FUSI gate can be tuned by varying the thickness of the as-deposited nickel layer that will determine which nickel-silicide phase will be formed during silicidation.

United States Patent No. 6,905,922 discloses a method for manufacturing FUSI gate MOSFET devices. According to this method, the MOSFET device, comprising a semiconductor gate electrode, source/drain regions and spacers alongside the gate electrode, is covered with a dielectric layer. By removing this dielectric layer from the semiconductor gate electrode, metal can be deposited on top of the semiconductor material to allow forming of the silicide.

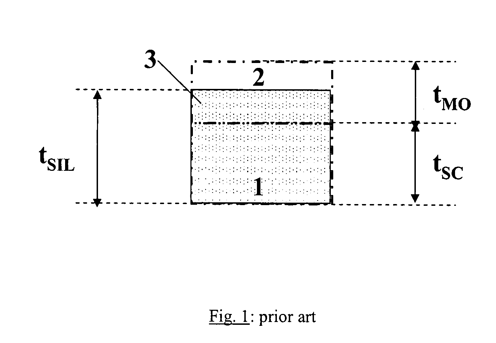

As known from M. A. Nicolet et al in "VLSI electronics: Microstructure Science, Vol. 6," editors: N.G. Einspruch and G. B. Larrabee, Academic Press, New York, 1983, chapter 6, pages 455 to 459, when forming a silicide 3 by the reaction between a semiconductor material 1 and a metal 2, the volume occupied by the silicide may be larger than the volume occupied by the semiconductor material 1. This phenomenon is illustrated in Figure 1 for a large structure in which the volume expansion is essentially a one-dimensional expansion and the thickness $t_{SIL}$ of the silicide layer 3 is larger than the thickness $t_{SC}$ of the as-deposited semiconductor layer 1.

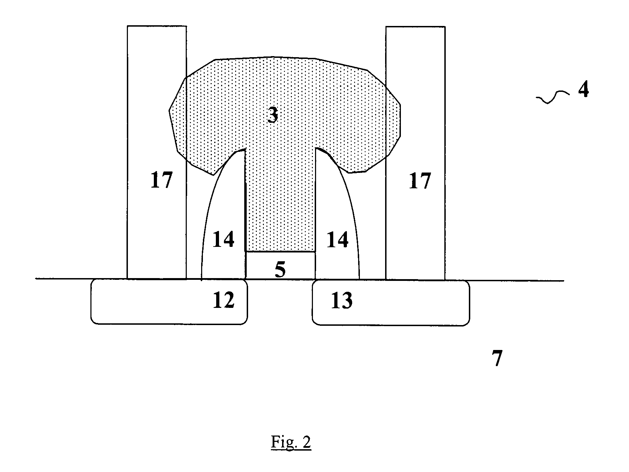

When forming a fully silicided gate, the silicide might extend over the spacers, which can cause a short-circuit to form between the fully silicided gate electrode 3 and contacts 17 towards the source/drain regions as illustrated by Figure 2. As seen in Figure 2, the fully silicided gate 3 expands over the spacers 14 and partially overlaps the source 12 and/or drain 13 region. Hence, there is need for a low complexity method to manufacture a fully silicided gate MOSFET device that prevents short-circuiting of the gate electrode with the contacts to the source and/or drain region.

**Summary of the Invention**

The present invention provides a method of manufacturing at least one MOSFET device having a fully silicided gate electrode, comprising the steps of:

- providing a gate stack consisting of a gate dielectric and a gate electrode, wherein the gate electrode has a thickness $t_V$, wherein at least a portion of the gate electrode in contact with the gate dielectric is formed in a semiconductor material, and wherein the sidewalls of the gate stack are wrapped by a dielectric layer;
- partially removing the gate electrode to obtain a layer thickness $t_{SC}$ of said semiconductor material in contact with said gate dielectric;
- depositing a layer of at least one silicidation metal on said semiconductor layer; and
- fully siliciding said semiconductor layer to form a silicide with a thickness $t_{SIL}$,

wherein $t_V$ and $t_{SC}$ are selected according to a relationship $t_V \geq T_{SIL} = t_{SC} (1+b)$ where $(1+b)$ is a volume expansion factor of the silicide.

Preferably, said dielectric layer wrapping the sidewalls of said gate stack are spacers.

Preferably, said spacers are formed by depositing a conformal layer of a dielectric material against the sidewalls of said gate stack and then anisotropically etching back said dielectric material.

In a method according to the invention, the step of partially removing said gate electrode can comprise the step of thinning the semiconductor material to obtain said semiconductor layer having a thickness $t_{SC}$.

Preferably, in a method of the invention, said semiconductor material is silicon.

Preferably, in a method of the invention, said silicidation metal is nickel.

Preferably, in a method of the invention, a portion of said gate electrode that is not in contact with said gate dielectric is formed in a material that can be selectively removed with respect to said semiconductor material.

Preferably, in a method of the invention, the step of partially removing the gate electrode comprises selectively removing said portion not in contact with said gate dielectric, to expose said semiconductor material.

Preferably, in a method of the invention said portion not in contact with said gate dielectric is formed in $Si_xGe_y$ (i.e. silicon germanium alloy).

In a method of the invention the step of fully siliciding said semiconductor material can comprise the step of providing a thermal budget to convert substantially all said semiconductor material into silicide and the step of removing any unreacted metal.

Alternatively, the step of fully siliciding said semiconductor material can comprise the step of providing a first thermal budget to convert partially said semiconductor material into silicide, the step of removing any unreacted metal, and the step of providing a second thermal budget for completion of the conversion of said semiconductor material into silicide.

A method of the invention, for manufacturing a MOSFET device having a fully silicided gate electrode can also be a method comprising the steps of:

- providing an electrode gate comprising (or consisting of) a semiconductor material having a thickness $t_{SC}$;
- forming a container having dielectric sidewalls on said semiconductor material and aligned thereto, wherein the container has a height $t_{CO}$;
- depositing a layer of at least one silicidation metal on the semiconducting material; and
- fully siliciding said semiconductor material to form a silicide having a thickness $T_{SIL}$,

wherein $t_{CO}$ and $t_{SC}$ are selected according to a relationship $t_{CO} \geq (b.t_{SC})$, where $t_{SIL}/t_{SC} = (1+b)$ is the volume expansion factor of the silicide formed.

Preferably, said semiconductor material is silicon.

Preferably, said silicidation metal is nickel.

Said step of fully siliciding said semiconductor material can comprise the step of providing a thermal budget to convert substantially all said semiconductor material into silicide and the step of removing any unreacted metal.

Alternatively, said step of fully siliciding said semiconductor material can comprise the step of providing a first thermal budget to convert partially said semiconductor material into silicide, the step of removing any unreacted metal, and the step of providing a second thermal budget for completion of the conversion of said semiconductor material into silicide.

**Brief Description of the Drawings**

Exemplary embodiments are illustrated in referenced figures of the drawings. It is intended that the embodiments and figures disclosed herein be considered illustrative rather than restrictive. Same numerals are used to refer to corresponding features in the drawings.

Figure 1 schematically illustrates volume expansion associated with the formation of a silicide.

Figure 2 schematically illustrates a problem that can occur when forming a fully silicided gate.

Figures 3a-e show schematic cross-sections illustrating a method for manufacturing a fully silicided MOSFET, according to an example.

Figures 4a-e show schematic cross-sections illustrating a process flow, according to an example.

Figures 5a-e show schematic cross-sections illustrating a process flow, according to another example.

**Detailed Description of the Invention**

A method of manufacturing at least one MOSFET device having a fully silicided gate electrode is described.

In one example, a gate stack of a gate dielectric and a gate electrode is provided. The gate electrode has a thickness $t_V$ and is wrapped along its sidewalls by a dielectric layer. At least the portion of the gate electrode in contact with the gate dielectric is formed in a semiconductor material. A part of this gate electrode is removed to form a layer of the semiconductor material having a thickness $t_{sc}$. A layer comprising at least one silicidation metal is deposited on this semiconductor layer, and this semiconductor layer is fully silicided to form a silicide having a thickness $t_{SIL}$. The dimensions $t_V$ and $t_{SC}$ are selected according to the relationship $t_V \geq t_{SIL} = t_{SC} (1+b)$, with $(1+b)$ being the volume expansion factor of the silicide formed. The gate stack is formed by forming a gate electrode on a gate dielectric and sidewall spacers are formed lying against this gate stack.

In another example, the complete gate electrode is formed in a semiconductor material and a part of this gate electrode is removed by thinning the semiconductor material to the semiconductor layer having a thickness $t_{sc}$.

In another example, the gate electrode consists of two portions. One portion is in contact with the gate dielectric and is formed of semiconductor material. This portion has a thickness $t_{sc}$. Another portion is not in contact with the gate dielectric and is formed in a material that can be selectively removed with respect to the semiconducting contact portion. This non-contacting portion is removed selectively such that the contact portion having a thickness $t_{sc}$ remains.

In another example, a method of manufacturing a MOSFET device having a fully silicided gate electrode is disclosed.

The method includes providing a semiconducting gate having a thickness $t_{SC}$; forming a container having dielectric sidewalls on this semiconductor gate and aligned thereto, the container having a height $t_{CO}$; depositing a layer of at least one silicidation metal on this semiconductor gate; and fully siliciding the semiconductor gate, the silicide having a thickness $t_{SIL}$. The height $t_{CO}$ and thickness $t_{sc}$ are selected according to the relationship $t_{CO} \geq (t_{SC} b)$, with $t_{SIL}/t_{SC} = (1+b)$ being the volume expansion factor of the silicide formed.

In one example, the container can be formed by forming a semiconducting gate, having a thickness equal to or greater than $T_{SIL}$; forming sidewall spacers against this semiconducting gate; and thinning this semiconducting gate to obtain a semiconductor gate having a thickness $t_{sc}$.

In another example, the container can be formed by stacking a material on top of the semiconductor gate that can be selectively removed with respect to the semiconducting gate; forming sidewall spacers against this layer stack; and removing the stacked portion to obtain a semiconductor gate having a thickness $t_{SC}$.

Preferably, the semiconductor material and the silicidation metal used to form the silicide are silicon and nickel, respectively.

In the context of the present invention, the terms "silicide", "silicided", "silicidation" can refer to the reaction between a metal and silicon, but is not intended to be limited to silicon. For instance, the reaction of a metal with Ge, or any other suitable semiconductor material, may still be referred to as silicidation.

In the framework of the present invention, the term "metal-rich silicide" refers to the material resulting from the reaction between said metal and said semiconductor, wherein the ratio metal-to-semiconductor is larger than 1.

Figure 1 shows a two-dimensional schematic cross-section of a stack of a first layer 1 comprising at least one semiconductor material, having thickness $t_{SC}$ and of a second layer comprising at least one metal 2, having thickness $t_{MO}$. The thickness of the metal layer 2 and the thickness of the semiconductor layer 1 are chosen so that substantially the whole semiconductor layer 1 is consumed upon silicidation.

The semiconductor layer can comprise silicon, germanium, silicon-germanium, or a combination thereof.

The metal layer can comprise refractory metals such as W, Ta, noble metals such as Pt, near noble metals such as Ni, transition metals such as Ti, Co, Pd, or any combination thereof.

When providing sufficient thermal energy to this stack 1, 2, substantially all semiconductor material(s) 1 will react with the metal(s) 2 forming a metallic layer 3 (dotted area) consisting of an alloy of both materials and a having thickness $t_{SIL}$.

This thermal energy can be provided in one or two thermal process steps, such as Rapid Thermal Processing (RTP), spike anneal, and laser anneal, which are well known in the art.

Any excess metal can be removed selectively to the alloy layer 3. This alloy layer 3 is also known as a silicide layer.

The volume of this alloy layer 3 can be larger than the volume of the first layer 1, as illustrated in Figure 1 for a large thin layer: $t_{SIL} > t_{SC}$.

The degree in which the volume of the alloy layer 3 increases with respect to the layer 1 of semiconductor material depends on the choice of semiconductor material(s) 1 and metal(s) 2 used to form the alloy layer 3, and on the silicide phase(s) in which this alloy layer is grown, as known from M. A. Nicolet et al in "VLSI electronics: Microstructure Science, Vol. 6", editors: N.G. Einspruch and G. B. Larrabee, Academic Press, New York, 1983, chapter 6, pages 455 to 459.

This increase in thickness is proportional to the metal content of the silicide layer 3. In the example of a nickelsilicide 3 formed by the reaction between nickel 2 and silicon 1, the expansion expressed by the thickness ratio $(T_{SIL} / t_{SC}) = (1+b)$ increases approximately from 1.1 (b = 0.1) for NiSi to about 1.63 (b = 0.63) for $Ni_2Si$ and to about 2.15 (b = 1.15) for $Ni_3Si$. In the case of $Ni_3Si$, the thickness of the gate electrode increases approximately by a factor 2.15, while in case of PtSi, the volume increases approximately by a factor of 1.7. Consequently, if a silicon layer having a thickness $t_{sc} = 100$ nm is fully consumed when forming a $Ni_3Si$ or PtSi silicide, the resulting silicide layer will have a thickness $t_{SIL}$ of respectively 215 nm and 170 nm.

As metal-rich silicides are preferably used to form a fully silicided gate electrode for pMOSFET devices, the problem of electrical shorts caused by the volume expansion is more pronounced for pMOSFET devices. W. Maszara et al discloses in "Transistors with Dual Work Function Metal Gates by Single Full Silicidation (FUSI) of Polysilicon gates", IEDM proceedings 2002 p367-370, hereby incorporated by reference in its entirety, polycrystalline silicon and nickel to be combined to form nickel-silicide. Various phases can be obtained; such as NiSi, $Ni_3Si_2$, $Ni_2Si$, $Ni_{31}Si_{12}$ and $Ni_3Si$ phase, depending on the amount of nickel deposited.

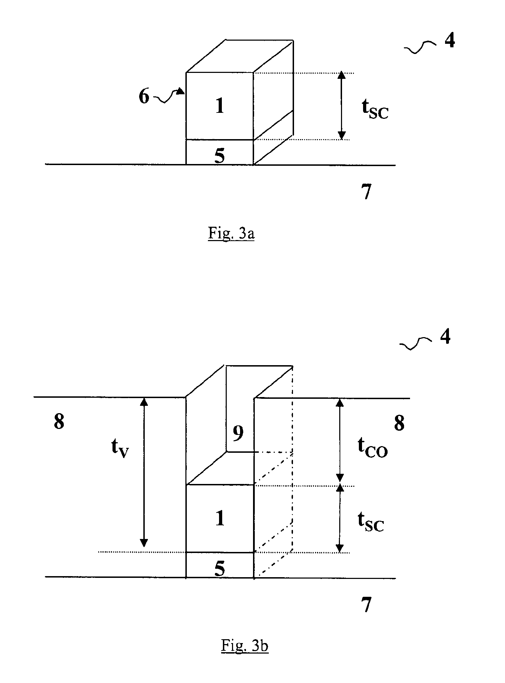

Figures 3a-d illustrate a method for manufacturing a fully silicided MOSFET.

A MOSFET device 4 is provided as shown in Figure 3a, comprising a gate electrode 6 and a gate dielectric 5 separating the gate electrode 6 from the substrate 7.

The gate electrode 6 is formed from semiconductor material(s) 1 and has a thickness $t_{SC}$.

A container 9 is created above the exposed surface of the gate electrode 6. This container 9 is defined by the gate electrode 6 and by the walls of a dielectric layer or stack of dielectric layers 8 surrounding at least the gate electrode 6 and extending from above the gate electrode 6 to a height $t_V$.

As shown in Figure 3b, a volume (9+1) is created having an opening opposite the substrate 7 and bordered by the dielectric layer 8 and the gate dielectric 5. This volume (9+1) has a height $t_V = t_{SC} + t_{CO}$ and is only partially filled with the semiconductor material(s) 1. On the exposed surface of the gate electrode 6, silicidation metal(s) 2 is/are deposited. This metal layer 2 has a thickness $t_{MO}$.

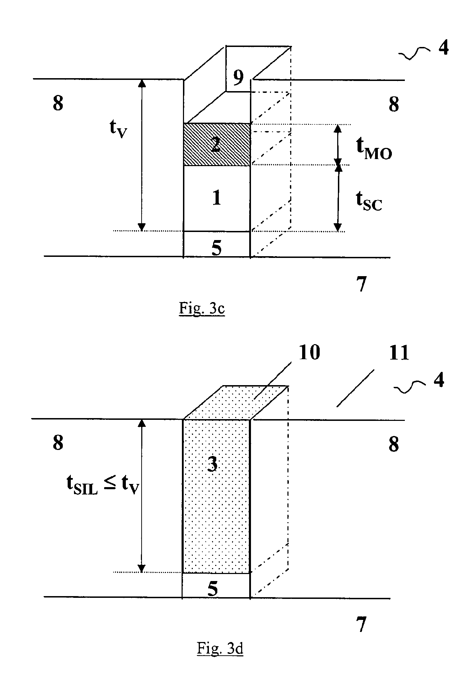

In Figure 3c, the metal layer only partially fills the container 9; however, the metal layer 2 may also completely fill or overfill the container 9.

By providing sufficient thermal energy, the metal(s) 2 and the semiconductor material(s) 1 react forming a silicide 3.

This silicide 3 can be formed using a one-step or a two-step silicide process.

In a one-step silicide process, only one thermal process step (e.g., by Rapid Thermal Processing (RTP)) is performed during which substantially all semiconductor material(s) 1 are converted into a silicide. Subsequently a selective wet etch is performed to remove any unreacted refractory metal(s) 2.

In a two-step silicide process, all or part of the semiconductor material(s) 1 are converted in a silicide in a first thermal process step. Subsequently, a selective wet etch is performed to remove any unreacted refractory metal(s) 2. Thereafter, in the second thermal process step, the silicide reaction is continued to either convert substantially all semiconductor material(s) 1 into a silicide 3 in the case in which no complete silicide was formed during the first thermal step, or to change the silicide phase in the case in which a fully silicided gate electrode was obtained during the first thermal process step.

Due to the confinement by the dielectric layer 8, the volume expansion is essentially an expansion in a direction away from the substrate 7.

As shown in Figure 3d, the thus-formed silicide 3 has a thickness $t_{SIL}$. The dimensions of the container 9, and hence of the volume (9+1), are chosen such that substantially all the silicide 3 is contained within the volume (9+1). The exposed surface 10 of the silicide 3 is at a level equal to or below the level of the exposed surface 11 of the dielectric layer 8.

Preferably, more metal 2 is provided than is consumed during full silicidation of the semiconductor layer 1. Preferably, about 10% metal in excess is deposited than is needed in order to ensure that sufficient metal 2 is available to convert substantially all semiconductor material(s) 1 into a silicide 3. This excess or unreacted metal is selectively removed after silicidation.

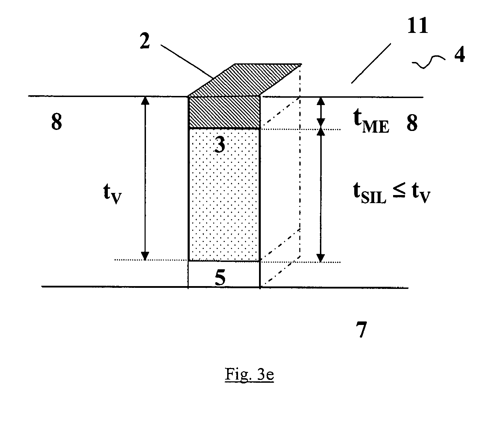

In Figure 3e, the exposed surface 10 of the silicide 3 is at a level below the level of the exposed surface 11 of the dielectric layer 8.

The unreacted metal ($t_{ME}$) on top is selectively removed, exposing the upper surface of the fully silicided gate electrode 3.

Several examples are included to illustrate the invention: if about 170 nm ($t_{MO}$) of nickel is deposited on about 100 nm ($t_{SC}$) polySi, about 215 nm ($t_{SIL}$) of $Ni_3Si$ is formed after full silicidation, or if about 109 nm ($t_{MO}$) of nickel is deposited on about 100 nm ($t_{SC}$) polySi, about 163 ($t_{SIL}$) of $Ni_2Si$ is formed after full silicidation.

In order to obtain silicide containment, the following relationships are obtained to correctly dimension the container 9:

$$t_V = t_{SC} + t_{CO} \geq t_{SIL} = t_{SC} (1+b) \qquad [1]$$

$$t_{CO} \geq b \ t_{SIL} \qquad [2]$$

where (1+b) is the volume expansion factor of the silicide formed and (b.$t_{SC}$) is the silicide layer thickness in excess of the semiconductor layer thickness $t_{SC}$.

As explained above, the value of b is determined by the choice of metal(s) and semiconductor material(s), and the silicide phase to be formed.

In the MOSFET device 4 shown in Figures 3a-d, only the dimension perpendicular to the substrate 7 is used as parameter for dimensioning the container 9 and hence the volume (9+1). In this example, the area of the container 9 in a plane parallel to the substrate 7 equals the area of the gate electrode 6 as the sidewalls of the container 9 are aligned to the sidewalls of the gate electrode 6. Preferably, the silicides are formed with an expansion factor (1+b) greater than 1.

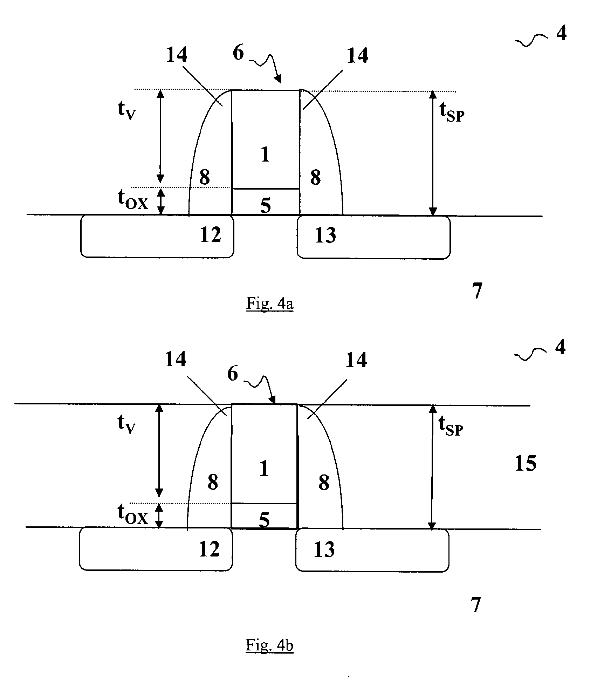

Figures 4a-e schematically illustrate an example process flow. Figure 4a shows a MOSFET device 4 formed on a substrate 7 comprising a gate electrode 6; a gate dielectric 5 in-between the gate electrode 6 and the substrate 7; sidewall spacers 14 formed in a dielectric material 8 adjacent to a stack of the gate electrode 6 and gate dielectric 5; source 12 and drain 13 junction regions aligned to the gate stack 6, 5 and extending underneath the sidewall spacers 14. The transistor 4 shown in Figure 4a can be any type of Metal-Oxide-Semiconductor Field-Effect-Transistor (MOSFET), such as a bulk transistor or a Multiple Gate transistor (MuGFET).

The gate dielectric 5 can be a siliconoxide, a siliconoxynitride, or a high-k dielectric (i.e. k>3,9), such as hafniumoxides, hafniumsilicates. The gate electrode 6 is formed from semiconductor material(s) 1, such as silicon, silicongermanium, or germanium.

As shown in Figure 4a, the gate electrode 6 of the MOSFET device 4 is preferably formed of a single semiconductor material 1, such as polycrystalline silicon or polycrystalline $Si_xGe_y$.

The substrate 7 can be a bulk semiconductor substrate, such as silicon or germanium wafer; or a semiconductor-on-insulator substrate, such as Silicon-On-Insulator (SOI) or Germanium-In-Insulator (GeOI).

The sidewall spacers 14 alongside the gate stack of gate electrode 6 and gate dielectric 5 are preferably formed by depositing a conformal layer or stack of layers of dielectric material 8 over the gate stack and by anisotropic etch of this dielectric layer(s) until the gate electrode 6 is exposed as is known in the art.

Typically, siliconoxide, siliconoxynitride, or siliconcarbide materials are conformally deposited and etched using a dry etch such as a reactive ion etch (RIE) or etch plasma.

The height $t_{SP}$ of the sidewall spacers 14 is determined by the height of the gate stack 5, 6: $t_{SP} = t_{OX} + t_V$. The volume (9+1) is formed by creating sidewall spacers 14 adjacent the gate electrode 6. The volume (9+1) has as surfaces the sides of the spacers 14 and of the gate dielectric 5 adjacent the gate electrode 6. The volume (9+1) is completely filled with the gate electrode 6 material. The MOSFET device shown in Figure 4a can be manufactured by standard semiconductor processes as known and appreciated by any person skilled in the art.

In Figure 4b, a dielectric layer stack 15 is deposited over the MOSFET device. This dielectric layer stack 15 is planarized by Chemical Mechanical Polishing (CMP) until the gate electrode 6 is exposed.

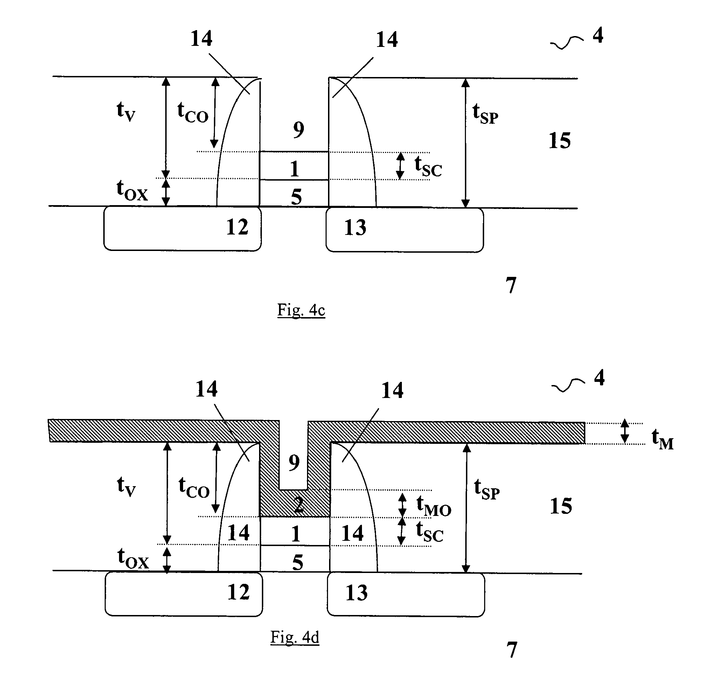

In Figure 4c, the gate electrode 6 is partially thinned by a selective etch back of the semiconductor material(s) until a semiconductor layer having a predetermined thickness $t_{sc}$ is left and a container 9 having a height $t_{co}$ is created. One way of dimensioning the volume (9+1) is given below. In correspondence with relationship [1] $t_V = t_{SC} + t_{CO}$ and relationship [2] $t_{CO} \geq b\, t_{SC}$, the volume height $t_V$ is determined in order to obtain a fully silicided gate electrode 3 having the desired thickness $t_{SIL}$ and which is substantially contained within the spacers 14.

By selecting the silicide to be formed, the volume expansion factor (1+b) is determined. Next the spacer height is defined $t_{SP} = t_V + t_{OX}$. For devices having a gate dielectric thickness $t_{OX}$ of about 2 nm or less, one can neglect the thickness $t_{OX}$ when determining the height of the volume (9+1): $t_{SP} = t_V$. The spacer height needed determines the thickness of the as-deposited semiconductor layer 1. For the selected silicide thickness $T_{SIL}$ and volume (9+1) height $t_v$, one can determine the thickness $t_{SC}$ of the semiconductor layer that is to remain: $t_{SC} = t_{SIL}/(1+b)$ and, hence, the thinning $t_{CO}$ of the as-deposited layer.

In Figure 4d, a layer of metal(s) 2 is deposited. This layer of metal(s) 2 has a thickness $t_{MO}$.

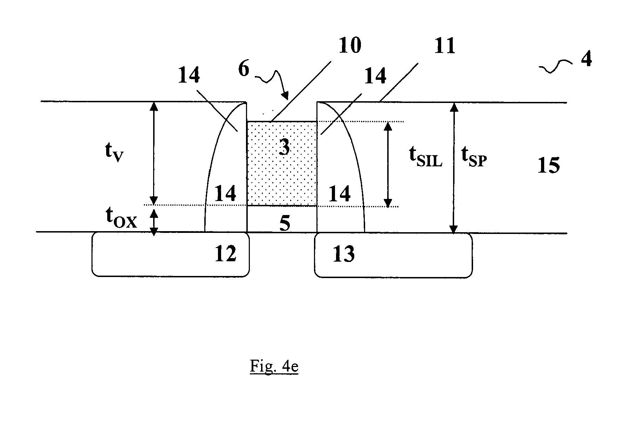

In Figure 4e, the semiconductor material(s) 1 and the metal(s) 2 have reacted to form a silicide 3 having a thickness $t_{SIL}$. By appropriate thinning of the gate electrode 1 until reaching the predetermined thickness $t_{SC}$, a container 9 is formed which can accommodate the volume expansion b of the silicide: $t_{CO} \geq b\, t_{SC}$. As shown in Figure 4e, the FUSI gate electrode 6 is fully contained within the sidewall spacers 14: $t_V = t_{SC} + t_{CO} > t_{SIL} = t_{SC}(1+b)$.

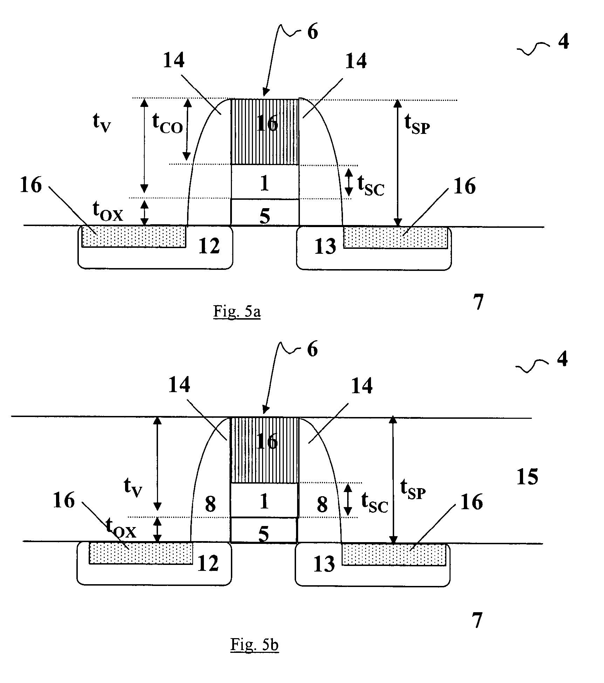

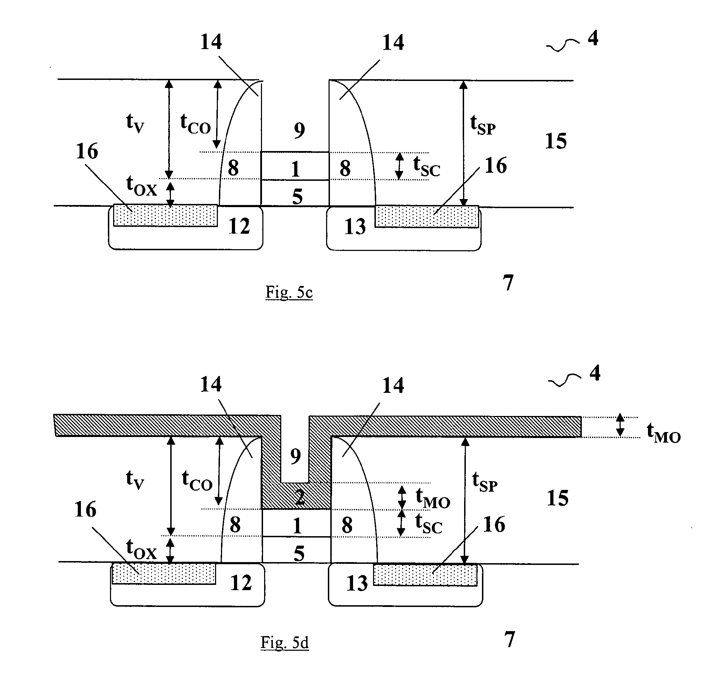

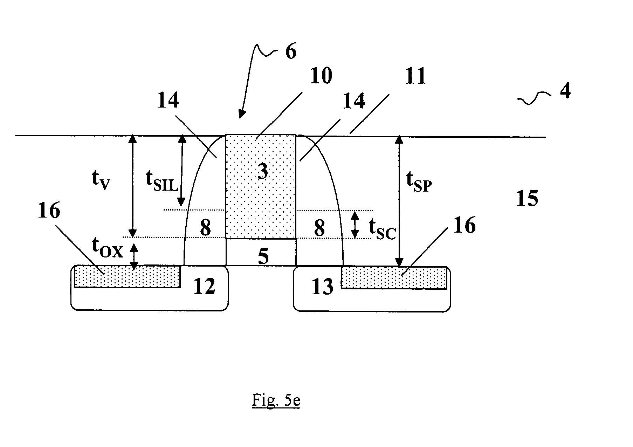

Figures 5a-c schematically illustrate another example process flow.

The MOSFET device 4 shown in Figure 5a differs from the MOSFET device 4 shown in Figure 4a in that its gate electrode 6 comprises a stack of two layers 16, 1 having a thickness of $t_{co}$ and $t_{sc}$, respectively. These thicknesses can be determined following the previously described procedure or by using the relationships [1] and [2].

These layers 16, 1 are formed in different materials, which are selected such that the exposed layer 16 can be selectively removed. The layer in contact with the gate dielectric 5 consists of at least one semiconductor material 1, while the exposed layer 16 can be a dielectric or a semiconducting material that can be selectively removed with respect to the contact portion 1.

The gate electrode 6 can be formed by uniformly depositing the desired layer stack 16, 1 on the substrate 7 and by patterning this layer stack to form the gate electrode 6, as is known by a person skilled in the art.

Optionally, the source 12 and drain 13 regions can be silicided 15 if care is taken that layer 1 is not affected. The exposed layer of the gate electrode 16 is either composed of materials that does not react with the metal(s) 2, such as dielectric materials (e.g., siliconnitride, siliconoxide, and siliconcarbide), or is formed from a semiconductor material, such as silicon-germanium or germanium, but is dimensioned to only partially consume when forming the silicide region 15 on source 12 and drain 13. The silicide formed at the gate electrode 6 during this process step does not extend to layer 1.

In Figure 5b, a dielectric layer stack 15 is deposited over the MOSFET device. This dielectric layer stack 15 is planarized by Chemical Mechanical Polishing (CMP) until the gate electrode 6 is exposed. This dielectric layer stack 15 masks the source 12 and drain 13 regions when forming the fully silicide gate electrode.

In Figure 5c, the top layer 16 of gate electrode 6 is selectively removed such that the semiconductor layer 1 is exposed. Preferably, this top layer 16 is formed from silicon-germanium, while the bottom layer 1 is formed from polycrystalline silicon. A dry etch process is used to remove the silicon-germanium plug 16 so that a semiconductor layer 1 having the predetermined thickness $t_{SC}$ remains and a container 9 is created having the predetermined height $t_{co}$.

In Figure 5d, a layer of material 2 having thickness $t_{MO}$ is uniformly deposited over the substrate.

Preferably, this layer is a nickel layer.

Preferably, the MOSFET device 4 is heated in a first thermal process step, such as Rapid Thermal Processing (RTP), to form a metal-rich fully silicide gate electrode 3 in the case in which the MOSFET device 4 is a pMOSFET and a metal-rich partially silicided gate electrode in the case in which the MOSFET device 4 is an nMOSFET.

Unreacted metal is removed yielding the MOSFET device 1 shown in Figure 5e.

The silicidation process is completed by a second thermal process step, such as Rapid Thermal Processing (RTP), in which a partially silicided nMOSFET the gate electrode 6 becomes fully silicided.

**Claims**

1. A method of manufacturing at least one MOSFET device having a fully silicided gate electrode, comprising the steps of:

   - providing a gate stack consisting of a gate dielectric (5) and a gate electrode (6), wherein the gate electrode (6) has a thickness $t_v$, wherein at least a portion of the gate electrode (6) in contact with the gate dielectric (5) is formed in a semiconductor material (1), and wherein the sidewalls of the gate stack are wrapped by a dielectric layer (8);
   - partially removing the gate electrode (6) to obtain a layer thickness $t_{SC}$ of said semiconductor material (1) in contact with said gate dielectric (5);
   - depositing a layer of at least one silicidation metal (2) on said semiconductor layer (1); and
   - fully siliciding said semiconductor layer (1) to form a silicide (3) with a thickness $T_{SIL}$,

   wherein $t_V$ and $t_{SC}$ are selected according to a relationship $t_V \geq t_{SIL} = t_{SC} (1+b)$, where $(1+b)$ is a volume expansion factor of the silicide.

2. A method according to claim 1, wherein said dielectric layer (8) wrapping the sidewalls of said gate stack are spacers (14).

3. A method according to claim 2, wherein said spacers (14) are formed by depositing a conformal layer of a dielectric material (8) against the sidewalls of said gate stack and then anisotropically etching back said dielectric material (8).

4. A method according to any of claims 1 to 3, wherein the step of partially removing said gate electrode (6) comprises the step of thinning the semiconductor material (1) to obtain said semiconductor layer having a thickness $t_{SC}$.

5. A method according to any of claims 1 to 4, wherein said semiconductor material (1) is silicon.

6. A method according to any of claims 1 to 5, wherein said silicidation metal is nickel.

7. A method according to any of claims 1 to 6, wherein a portion (16) of said gate electrode (6) that is not in contact with said gate dielectric (5) is formed in a material that can be selectively removed with respect to said semiconductor material (1).

**8.** A method according to claim 7, wherein the step of partially removing the gate electrode (6) comprises selectively removing said portion (16) not in contact with said gate dielectric (5), to expose said semiconductor material (1).

**9.** A method according to claim 7 or 8, wherein said portion (16), not in contact with said gate dielectric (5), is formed in $Si_xGe_y$.

**10.** A method according to any of claims 1 to 9, wherein the step of fully siliciding said semiconductor material (1) comprises the step of providing a thermal budget to convert substantially all said semiconductor material (1) into silicide (3) and the step of removing any unreacted metal.

**11.** A method according to any of claims 1 to 9, wherein the step of fully siliciding said semiconductor material (1) comprises the step of providing a first thermal budget to convert partially said semiconductor material (1) into silicide, the step of removing any unreacted metal, and the step of providing a second thermal budget for completion of the conversion of said semiconductor material (1) into silicide (3).

**12.** A method of manufacturing a MOSFET device having a fully silicided gate electrode, comprising the steps of:

- providing an electrode gate comprising (or consisting of) a semiconductor material (1) having a thickness $t_{SC}$;
- forming a container (9) having dielectric sidewalls on said semiconductor material (1) and aligned thereto,

wherein the container (9) has a height $t_{CO}$;

- depositing a layer of at least one silicidation metal (2) on the semiconducting material (1); and
- fully siliciding said semiconductor material (1) to form a silicide (3) having a thickness $t_{SIL}$,

wherein $t_{CO}$ and $t_{SC}$ are selected according to a relationship $t_{CO} \geq (b.tsc)$, where $t_{SIL}/t_{SC} = (1+b)$ is the volume expansion factor of the silicide formed.

$t_{MO}$

$t_{SIL}$

$t_{SC}$

3

2

1

Fig. 1: prior art

Fig. 2

Fig. 3a

Fig. 3b

Fig. 3c

Fig. 3d

Fig. 3e

EP 1 744 351 A2

$t_V$

$t_{SP}$

14  6  14  4

1

8  8

$t_{OX}$

5

12  13

Fig. 4a

7

$t_V$

$t_{SP}$

14  6  14  4

1

8  8

15

$t_{OX}$

5

12  13

7

Fig. 4b

EP 1 744 351 A2

14    14    ~4

$t_V$  $t_{CO}$

9

$t_{SP}$

15

1  $t_{SC}$

$t_{OX}$  5

12    13

7

Fig. 4c

14    14    ~4

$t_M$

$t_V$  $t_{CO}$

9

2

$t_{SP}$

15

$t_{MO}$

14  1  14  $t_{SC}$

$t_{OX}$  5

12    13

Fig. 4d

7

Fig. 4e

Fig. 5a

Fig. 5b

EP 1 744 351 A2

Fig. 5c

Fig. 5d

Fig. 5e

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6905922 B

**Non-patent literature cited in the description**

- **W. MASZARA et al.** Transistors with Dual Work Function Metal Gates by Single Full Silicidation (FUSI) of Polysilicon gates. *IEDM proceedings,* 2002, 367-370

- **M. A. NICOLET et al.** VLSI electronics: Microstructure Science. Academic Press, 1983, vol. 6, 455-459